# EUROPÄISCHE PATENTANMELDUNG

(11) **EP 1 818 609 A2**
(43) Veröffentlichungstag der Anmeldung: **15.08.2007**
(21) Anmeldenummer: 07101069.8
(22) Anmeldetag: 24.01.2007
(51) Int. Cl.: F21V 31/03

(54) **Trocknungseinrichtung für lichttechnische oder elektronische Geräte**

(30) Priorität: 10.02.2006 DE 102006006099
(71) Anmelder: Hella KGaA Hueck & Co., 59552 Lippstadt (DE)
(72) Erfinder: Kalwa, Matthias, Dr., 59555, Lippstadt (DE); Siekmann, Wolfgang, 59555, Lippstadt (DE); Wiese, Thomas, Dr., 59556, Lippstadt (DE)
(74) Vertreter: Downar, Michael

(57) **Zusammenfassung**

Die Erfindung betrifft eine Trocknungseinrichtung für lichttechnische oder elektronische Geräte. Ein Trocknungsmittel dient zur Aufnahme von Luftfeuchte aus einer im Inneren des Gerätes befindlichen Innenluft und zur Abgabe einer aufgenommen Luftfeuchte an eine Außenluft. Ein elektrisch ansteuerbares Verstellelement ist zwischen einer Adsorptions- und Desorptionseinstellung bewegbar. Zumindest ein Teil des Trocknungsmittels steht in der Adsorptionseinstellung mit der Innenluft zur Aufnahme der Luftfeuchte und in der Desorptionseinstellung mit der Außenluft zur Abgabe der Luftfeuchte in Verbindung.

## Beschreibung

Die Erfindung betrifft eine Trocknungseinrichtung für lichttechnische oder elektronische Geräte mit einem Trocknungsmittel, das zur Aufnahme von Luftfeuchte aus einer im Inneren des Gerätes befindlichen Innenluft und zur Abgabe einer aufgenommenen Luftfeuchte an eine Außenluft dient.

Eine solche, aus der DE-A-22 22 449 bekannte Trocknungseinrichtung ist für ein lichttechnisches Gerät, das ein Scheinwerfer ist, vorgesehen. Der Scheinwerfer besteht im wesentlichen aus einem schalenförmigen Reflektor, einer das Reflektorinnere abdeckenden Lichtscheibe, einer in die Öffnung im Scheitel des Reflektors eingesetzten Glühlampe und einem in einer heißen Zone oberhalb der Glühlampe angeordneten, mit Trocknungsmittel gefüllten, Kanal, der von einem stabförmigen Rohr gebildet ist. Das Rohr ist in eine Öffnung des Reflektors eingesetzt und verbindet durch den eine Eingangs- und Ausgangsöffnung aufweisenden Kanal die Luft im Innenraum des Scheinwerfers mit der den Scheinwerfer umgebenden Luft. Bei einem unterschiedlichen Luftdruck zwischen dem Innenraum des Scheinwerfers und seiner Umgebung strömt Luft durch den Kanal des Rohres, dessen Mantelflächenabschnitt zwischen seiner Eingangsund Ausgangsöffnung für die Luftströmung dicht ausgeführt ist. Das in den Kanal des stabförmigen Rohres eingefüllte, reversibel arbeitende, hygroskopische Trocknungsmittel bindet bei niedrigen Temperaturen Feuchtigkeit durch Adsorption und desorbiert bei höheren Temperaturen die adsorbierte Feuchtigkeit.

Bei einem solchen Scheinwerfer kann im Fahrbetrieb des Fahrzeugs sichergestellt sein, dass der Innenraum des Scheinwerfers ausreichend frei von Feuchtigkeit ist und somit auf der Reflexionsfläche des Reflektors und der Lichtscheibe kein Wasser kondensiert, das einen korrosiven Schaden oder durch Tröpfchenbildung hervorgerufene Beeinträchtigung des Lichts bewirken kann. Hierzu folgende Begründung:

Nach einem Abschalten der Glühlampe des Scheinwerfers kühlt sich die Luft im Innenraum des Scheinwerfers ab und zieht sich zusammen. Dadurch wird in den Innenraum des Scheinwerfers Luft aus der Umgebung durch den mit Trocknungsmittel gefüllten Kanal des Rohres bis zum Druckausgleich angesaugt. Die in der einströmenden Luft enthaltene Feuchtigkeit wird in dem Trocknungsmittel durch Adsorption gebunden. Aus diesem Grunde kann die Feuchtigkeit nicht in den Innenraum des Scheinwerfers gelangen.

Nach einem Einschalten der Glühlampe des Scheinwerfers erhöht sich die Temperatur der in dem Innenraum des Scheinwerfers befindlichen Luft, die sich dadurch ausdehnt und durch den mit Trocknungsmittel gefüllten Kanal des Rohres nach außen ausströmt. Durch Aufheizen des Trocknungsmittels erfolgt eine Desorption der bereits in dem Trocknungsmittel adsorbierten Feuchtigkeit, die die nach außen strömende Luft mitnimmt. Dadurch erfolgt eine Regeneration des Trocknungsmittels. Das stabförmige Rohr ist in einem Abstand oberhalb der Glühlampe angeordnet, damit das Trocknungsmittel bei eingeschalteter Glühlampe auf eine möglichst hohe Desorptionstemperatur erhitzt wird.

Wurde bislang die innere Kondensation bzw. Betauung nicht als sicherheitsrelevantes, sondern eher als dekoratives Problem angesehen, ändert sich diese Einstufung jedoch mit dem Einsatz neuer lichttechnischer und sensierender Funktionen. Diese sind nachstehend anhand eines Kurvenlicht-Scheinwerfers, Scheinwerfer mit LED-Lichtquellen und Scheinwerfer mit Sensoren beschrieben.

### Kurvenlicht-Scheinwerfer

Wird beispielsweise das Abblendlicht eines Hauptscheinwerfers durch ein schwenkbares Modul dargestellt, um die Funktion "dynamisches Kurvenlicht" zu realisieren, kann im Fall einer Scheinwerferbetauung beim Fahren durch eine Kurve die Abblendlichtfunktion völlig zusammenbrechen. Während der Geradeausfahrt heizt der Infrarot-Anteil des Lichtes den primären Lichtaustritt der Abschlussscheibe stark auf, so dass sich dort keine Betauung dauerhaft halten kann ("Freibrennen"). Schwenkt das Lichtbündel jedoch in einen benachbarten Bereich der Abschlussscheibe, wird dort die Abschlussscheibe wegen der selteneren Bestrahlung nur ungenügend erwärmt und durch den ständig wirkenden Fahrtwind von außen auf vergleichsweise niedrigem Temperaturniveau gehalten, so dass sich dort Betauung über einen längeren Zeitraum halten kann. Die optische Wirkung der Wassertröpfchen führt dann zu einer starken Streuung des eigentlich gerichtet abzugebenden Lichtes, was einerseits zu einer verstärkten Blendung des Gegenverkehrs führt. Andererseits kommt es wegen der mangelnden Ausleuchtung der Straße zu kritischen Sichtverhältnissen; die Sichtverhältnisse bei Kurvenfahrt können dann schlechter sein als im Fall eines statischen Abblendlichtes.

### Scheinwerfer mit LED-Lichtquellen

Bei Einsatz halbleiterbasierter Lichtquellen (LED) im Scheinwerfer stellt sich der Betauungsfall besonders kritisch dar, weil die Verlustleistung der Lichtquelle quasi strahlungsfrei (keine signifikanten Infrarot-Anteile) abgegeben wird; d.h. die Verlustleistung muss durch Kühlkörper abgeleitet und einem Kühlmittel-Strom zugeführt werden. Die Abschussscheibe wird dann auch im primären Lichtaustritt nicht nennenswert erwärmt, so dass oben genanntes Freibrennen nicht stattfindet. Im Betauungsfall sind dann die kritischen Sichtverhältnisse und die erhöhte Blendung des Gegenverkehrs auch bei normaler Geradeaus-Fahrt zu erwarten. Es gibt Überlegungen, die konvektive Abwärme zur Erwärmung der Abschlussscheibe zu nutzen, was wegen des intensiven Wärmeübergangs zwischen der Abschlussscheiben-Außenfläche und des Fahrtwinds jedoch nur in Grenzen gelingt und erhebliche Kompromisse seitens des Bauraumbedarfes, des Stylings und der Kosten erfordert.

### Scheinwerfer mit Sensoren

Ein "sehender" Sensor im Scheinwerfer erzeugt im Allgemeinen keine zur Abschlussscheiben-Erwärmung signifikant beitragenden Strahlungsströme.

### Aktiv beleuchtende Sensorsysteme

Selbst bei Infrarot-Sensoren mit ausgesandtem, "tastendem" Strahlungsfeld (aktiv beleuchtende Sensorsysteme) wird naturgemäß eine Arbeits-Wellenlänge gewählt, die keine nennenswerte Dämpfung beim Durchtritt durch die Abschlussscheibe erfährt. Geschieht die Erzeugung der ausgesandten Infrarot-Strahlung schmalbandig (z.B. durch Halbleiter-Lichtquellen wie LEDs), ist auch hier keine langwellige, die Abschlussscheibe durch Adsorption aufheizende Strahlung enthalten. Somit erfährt schon die ausgesandte Strahlung im Betauungsfall eine Streuung beim Durchtritt durch die Abschlussscheibe; das hat im allgemeinen Nachteile für die Reichweite der Sensoren zu Folge.
Bei aktiv beleuchtenden Sensorsystemen, die Sender und Empfänger innerhalb eines Gehäuses hinter einer gemeinsamen Abschlussscheibe umfassen, kann die am Kondensat direkt auf den Sensor rückgestreute ausgesandte Strahlung zudem das eigentlich zu detektierende, von der Straßenszenerie reflektierte Signal bis zur Unkenntlichkeit überdecken.

### Passive Sensorsysteme

Der von der Straßenszenerie reflektierte Teil der ausgesandten Infrarot-Strahlung bei aktiv beleuchtenden Sensorsystemen ist im Folgenden vergleichbar dem von der Straßenszenerie emittierten Strahlungsfluss, das von passiven Sensorsystemen detektiert wird. In beiden Fällen ist die Strahlungsdichte des von außen durch die Abschlussscheibe durchtretenden Strahlungsflusses zu gering, um eine signifikante Erwärmung der Abschlussscheibe zu erzeugen. Im Fall einer inneren Betauung wird dieser Strahlungsfluss an den Wassertröpfchen wiederum gestreut, so dass der den eigentlichen Sensor letztlich erreichende Strahlungsfluss noch weiter abgemindert wird. Auch dieser Effekt führt schließlich zu einer Reduzierung der Reichweite des Sensors bzw. im Extremfall sogar zu seiner Erblindung.
Der Erfindung liegt die Aufgabe zugrunde, die im Oberbegriff des Anspruchs 1 beschriebene Trocknungseinrichtung für lichttechnische oder elektronische Geräte derart zu verbessern, dass der Transport der Feuchte von der Innenluft des Gerätes zur Außenluft hin effektiver ist. Diese Aufgabe wird durch die kennzeichnenden Merkmale des Anspruchs 1 gelöst. Dadurch kann das Trocknungsmittel ortsfest angeordnet sein oder das Verstellelement haltert das Trocknungsmittel und bewegt dieses in die Desorptions- bzw. Adsorptionseinstellung.

Wenn das Verstellelement das Trocknungsmittel haltert, handelt es sich um ein aktives System, weil Feuchte aktiv aus dem Geräteinneren nach außen gegen ein Wasserdampfdruck-Gefälle transportierbar ist. Das Trocknungsmittel nimmt kontinuierlich oder phasenweise aus dem Geräte-Inneren Feuchtigkeit auf (Trocknungs-Phase) und gibt kontinuierlich oder phasenweise die aufgenommene Feuchte an die Umgebung ab (Ausheiz-Phase). Das Trockenmittel ist in der Adsorptionseinstellung (Trocknungsphase) zur Feuchteaufnahme konvektiv oder diffusiv mit dem Geräteinnenraum verbunden. Während der Trocknungsphase ist es von Vorteil, wenn das Geräteinnere weitgehend gegen die Geräteumgebung abgedichtet ist. Dadurch wird vermieden, dass der Trocknungseffekt relativ schnell durch von außen nachdiffundierende Feuchtigkeit kompensiert wird, was letztendlich eine Reduzierung der Effizienz des Trocknungssystems bedeuten würde. Das sinngemäß gleiche gilt, wenn während der Ausheizphase durch eine nicht ausreichende Abdichtung zwischen Trocknungsmittel und Geräteinnenraum ausgeheizte Feuchtigkeit in das Geräteinnere zurückschlägt. Somit ist für ein effizientes Trocknungssystem folgendes vorteilhaft:
1. Während der Trocknungsphase besteht eine möglichst gute Verbindung (kleiner Diffusionswiderstand) zwischen Innenraum (Innenluft) und Trocknungsmittel und eine gute Abdichtung des Innenraums gegenüber der Außenluft.
2. Während der Ausheizphase besteht dagegen eine gute Verbindung zwischen Trockenmittel und Umgebung sowie eine gute Abdichtung des Innenraums gegen das Trockenmittel.

Diese beiden Forderungen bedeuten letztendlich unterschiedliche Verbindungen zwischen zwei Gasräumen (Innenluft und Außenluft) und sind im selben System durch ein mechanisch bewegtes Verstellelement erfüllt.

Die Innenluft des Geräteinnenraums wird dadurch getrocknet, dass ein Trockenmittel während der Trocknungsphase im Geräteinneren positioniert wird, so dass es dort Feuchtigkeit aufnehmen kann, wodurch der Wasserdampfpartialdruck im Innenraum abgesenkt wird. Wenn ein bestimmter Sättigungsgrad des Trockenmittels erreicht ist, wird das Trockenmittel zu Beginn der Ausheizphase aus dem Geräteinneren nach außen transportiert und dort ausgeheizt; ist ein bestimmter Trocknungsgrad erreicht, wird das Trockenmittel wieder in das Geräteinnere transportiert, kühlt dort ab und es beginnt wieder die Trocknungsphase. Das Geräteinnere bleibt dabei ausreichend gut abgedichtet gegenüber der Umgebung, so dass das Eindringen von Umgebungsfeuchte ins Geräteinnere minimiert wird. Die Trocknung kann kontinuierlich und diskontinuierlich betrieben werden.

Bei kontinuierlicher Trocknung durchläuft das Trockenmittel z.B. als ein Trockenmittelband in einer Endlosschleife das Geräteinnere, gelangt durch einen Dichtschlitz in die äußere Umgebung, wird dort (durch Heißluft, Strahlung und/oder eine mitlaufende oder schleifende Kontaktheizung) erwärmt, gibt einen Teil der aufgenommenen Feuchte ab und gelangt durch einen weiteren Dichtschlitz wieder ins Geräteinnere, kühlt dort ab und nimmt wieder Feuchtigkeit auf.
Eine weitere vorteilhafte Bauform für ein kontinuierlich verstellbares Verstellelement ist eine rotierende Scheibe (bzw. Zylinder), die an den Stirnflächen (bzw. Mantelfläche) im Geräteinneren Feuchtigkeit aufnimmt und außerhalb des Gerätes durch Beheizung die Feuchtigkeit wieder abgibt.

Besonders vorteilhaft ist es, wenn das Trocknungsmittel offen-porös bzw. von Strömungskanälen durchzogenen ist, die vom Gasstrom der Innen- bzw. Außenluft selbst durchströmt werden können; durch ihre große spezifische Oberfläche (kurze Diffusionswege im Trockenmittel) werden so besonders kleine Trocknungseinrichtungen mit hoher Trocknungsleistung ermöglicht.

Ein wesentliches Element der Trocknungseinrichtung ist die "Ausheizvorkammer", in der sich die Trockenmittel-Vorlage nominell zwar außerhalb des Geräteinnenraumes befindet und dennoch der Geräteumgebung nicht schutzlos ausgesetzt wird. Die Ausheizvorkammer wird durch eine Kammer gebildet, die gegen den Geräteinnenraum weitgehend abgedichtet ist, eine gute konvektive und / oder diffusive Verbindung zum Gasraum der Geräteumgebung aufweist und die Trockenmittel-Vorlage beim Ausheizen gegen Spritzwasser aus der Geräteumgebung schützt.

Weiterhin ist es vorteilhaft, wenn die Ausheizvorkammer mit der Umgebung konvektiv gekoppelt ist. Die Ausheizvorkammer besteht aus festen Wänden, die so angeordnet sind, dass wenigstens zwei Öffnungen entstehen, die sich auf unterschiedlicher Bauhöhe befinden, so dass durch eine Erwärmung der Luft in der Ausheizvorkammer eine Durchströmung induziert wird, die einen Gasaustausch mit der Geräteumgebung erzwingt. Eine solche Anordnung sorgt für einen ausreichenden Spritzwasserschutz.

Weiterhin ist es vorteilhaft, wenn eine Öffnung der Ausheizvorkammer an deren tiefsten Punkt angeordnet ist, so dass im Inneren der Ausheizvorkammer entstehendes Kondensat abfließen kann und kein ständiges Reservoir bilden kann.

Das Gerät ist watfähig, wenn die Ausheizvorkammer aus den festen Wänden und einer dampfdurchlässigen, wasserundurchlässigen Membran (z.B. GoreTex u.ä.) besteht, die die Ausheizvorkammer zur Geräteumgebung hin bis auf eine Öffnung am tiefsten Punkt der Ausheizkammer vollständig verschließt. Die aus der Trockenmittelvorlage desorbierte Feuchtigkeit gelangt hier teilweise auf diffusivem Wege und teilweise als durch diese eine Öffnung abfließendes Kondensat in die Geräteumgebung. Das Gerät ist watfähig, solange sich diese eine Öffnung der Ausheizvorkammer oberhalb des Watwasserspiegels befindet. Zur Verbesserung des Schwall- bzw. Spritzwasserschutzes ist es vorteilhaft, diese Anordnung durch einen rohrförmigen Fortsatz, der diese eine Öffnung mit der Geräteumgebung verbindet derart zu ergänzen, dass innerhalb der Ausheizvorkammer entstehendes Kondensat durch den rohrförmigen Fortsatz ungehindert abfließen kann.

Das Gerät ist tauchfähig, wenn das Gerät keine weitere Belüftungsöffnung aufweist, druckdicht gestaltet ist und die Ausheizvorkammer aus den festen Wänden und einer dampfdurchlässigen, wasserundurchlässigen Membran (z.B. GoreTex u.ä.) besteht, die die Ausheizvorkammer ohne Öffnung zur Geräteumgebung hin vollständig verschließt. Die aus der Trockenmittelvorlage desorbierte Feuchtigkeit gelangt dann nur auf diffusivem Wege durch die Membran hindurch in die Geräteumgebung. Es ist vorteilhaft, die Membran ein- oder beidseitig durch ein Gitter mechanisch zu stützen, um einen Membranbruch bei auftretenden Druckdifferenzen zwischen Geräte-Innerem und der Geräteumgebung zu vermeiden.
Vorteilhaft ist es beim kontinuierlichen bewegbaren Verstellelement weiterhin, dass die Trocknungseinrichtung zu beliebigen Zeitpunkten abgeschaltet werden kann, ohne dass damit ein kritischer Zustand eingefroren werden kann, der z.B. bei einer Wiederinbetriebnahme zu einer Initial-Betauung des Gerätes führen könnte.

Ein diskontinuierlich bewegbares Verstellelement bewegt das Trocknungsmittel z.B. translatorisch und/oder rotatorisch oszillierend. Der Trockenmittelkörper befindet sich während der Adsorptionseinstellung im Geräteinneren und wird beim Übergang zur Ausheizphase mit einem kurzen Bewegungsablauf (Umschaltbewegung) in eine zweite stationäre Position außerhalb des Gerätes gebracht. Beim umgekehrten Übergang erfolgt die umgekehrte Bewegung, so dass das mechanische System zwei stationäre Positionen anfährt. In diesem Zusammenhang ist es vorteilhaft, wenn eine der beiden Positionen im Stromlos-Zustand immer z.B. durch Federkraft angefahren wird. Auch beim diskontinuierlichen Verstellelement sind die oben beschriebene Ausheizkammer und poröse Trocknungsmittel von Vorteil.

Bei der erfindungsgemäßen Trocknungseinrichtung sind drei Positionen vorteilhaft, von denen eine im Stromlos-Zustand angefahren wird und die beiden anderen der Trocknungs- bzw. Ausheizphase zugeordnet sind. In diesem Fall wird z.B. im Stromlos-Zustand eine zweite Belüftungsöffnung aktiviert, so dass das Gerät dann durchlüftet ist; dagegen wird in den beiden andern Positionen diese Zusatzöffnung geschlossen gehalten, um die Trocknungs-Effizienz zu maximieren. Insbesondere wenn der Stromlos-Zustand nicht sofort beim Abstellen des Fahrzeuges aktiviert wird (bedeutet Ruhestrombedarf), hat diese Ausführung den Vorteil, dass es im Geräteinneren nicht zur Feuchtigkeitskumulation bei langen Stillstandphasen durch Sättigung des Trockenmittels kommen kann.

Vorteilhaft beim diskontinuierlichen bewegbaren Verstellelement ist, wenn eine Abdichtung des Verstellelements in den beiden Endpositionen besteht.

Ein weiterer Vorteil beim diskontinuierlich bewegbaren Verstellelement besteht, wenn das Heizelement vom Trocknungsmittel umgeben ist. Dadurch ist wenig Heizenergie erforderlich, um die Desorptionstemperatur des Trockenmittels zu erreichen. Besonders vorteilhaft ist es, wenn das Verstellelement aus einem Grundkörper und dem Trocknungsmittel besteht. In ein poröses Trockenmittel (z.B. Molekularsieb), dringt die Feuchtigkeit relativ tief in das Trockenmittel ein, so dass eine entsprechend hohe Schichtdicke sinnvoll sein kann. Wird ein kompaktes Trockenmittel verwendet (z.B. Polymere), dringt die Feuchtigkeit innerhalb der typischen Phasendauer von wenigen Minuten aufgrund des relativ hohen inneren Diffusionswiderstandes in eine nur wenige zig µm dicke Oberflächenschicht ein; die optimale Schichtdicke hängt dann entscheidend vom Trockenmittel selbst, aber auch von der Phasendauer ab. In diesen Fällen reichen entsprechend dünne Trockenmittelschichten aus, wie z.B. dünne Schichten spezieller Lacke auf einem Metallträger. Eine solche Anordnung hat den Vorteil, mit wenig Aufwand homogen beheizbar zu sein, wenn der Metallträger eine Wärmeverteil-Funktion unterstützt. Wird als Träger z.B. ein Aluminiumprofil verwendet, reicht zur Beheizung ein einfacher Leistungswiderstand aus, der an diesem Profil mit gutem thermischem Kontakt befestigt wird. Wird ein hochverripptes, beschichtetes Profil verwendet, kann mit diesem Widerstand eine große Oberfläche effizient und homogen ausgeheizt werden. Die Beschichtung dient entweder selbst als Trockenmittel oder als Bindemittel bzw. Klebeschicht für das Trockenmittelgranulat bzw. -pulver.

Weiterhin ist es vorteilhaft, wenn das Trockenmittel aus einem homogenen Material besteht. Wird als Trockenmittel ein Polymer (z.B. PA) verwendet, kann ein Heizleiter in ein Kunststoffteil eingebettet sein. Hierbei ist es weiterhin vorteilhaft, wenn das Polymere mit Zuschlagstoffen versehen ist, die seine Wärmeleitfähigkeit erhöhen; das senkt einerseits die Anzahl der erforderlichen Heizleiter, erhöht andererseits aber auch den inneren Diffusionswiderstand des Polymeren.

Weiterhin ist es beim kontinuierlich bewegbaren Verstellelement vorteilhaft, dass keine aufwändigen Sensoren oder Regelungen notwendig sind und es mit einer konstanten Umlaufgeschwindigkeit und Heizleistung betrieben werden kann.

Beim diskontinuierlich bewegbaren Verstellelement kann in einem festen Zeitraster zwischen Trocknungs- und Ausheizphase umgeschaltet (konstante Umschaltperiode) werden und die Trocknungseinrichtung ebenfalls mit konstanter Heizleistung betrieben werden.

Bei hohen Anforderungen an die Trocknungseffizienz (große Trocknungsleistung, kleine Trockner-Baugröße), ist eine temperaturgeregelte Ausheizung vorteilhaft. Dadurch wird das Trockenmittel optimal getrocknet in den Innenraum zurückzutransportiert bzw. eine Überhitzung des Trockenmittels oder der Binderschicht vermieden. Zur Steigerung der Trocknungseffizienz ist es vorteilhaft, wenn die charakteristische Transportgröße (Umlaufgeschwindigkeit bzw. Umschaltperiode) in Abhängigkeit von der Dampfdruck-Differenz zwischen Innraum und Umgebung geregelt wird. Weiterhin kann die Effizienz im Sinne des Bauraumbedarfes durch Trockenmittel und Trockenmittelkörpergeometrien mit optimalen Eigenschaften durch nachstehende Merkmale erhöht werden:
· geringer Diffusionswiderstand im Trockenmittel,
· große volumenspezifische Oberfläche,
· gute Durchströmung (niedriger Druckverlust beim Durchströmen),
· geringes verschlepptes Luftvolumen,
· gleichmäßige Erwärmung des ganzen Trockenmittelkörpers beim Ausheizen und anschließende gleichmäßige Abkühlung (gute Wärmeleitfähigkeit).

Beim diskontinuierlichen bewegbaren Verstellelement ist es vorteilhaft, dieses mit asymmetrischen Umschaltzeiten (längere Trocknungs - kürzere Ausheizphase) zu betreiben, weil die Ausheizphase wegen der thermisch bedingt erhöhten Diffusionskoeffizienten wesentlich schneller in die Sättigung läuft als die Trocknungsphase.

Beim diskontinuierlichen bewegbaren Verstellelement ist es weiterhin vorteilhaft, wenn für die Bewegung des Verstellelements und des Trockenmittels ein Antriebssystem verwendet wird, das während der Heizphase (Trockenmittel außerhalb des Geräteinnenraumes) bestromt ist und im stromlosen Zustand durch Federkraft in die Stellung "Trocknen" (Trockenmittel innerhalb des Geräteinnenraumes) zurückfällt. Die Bewegungssteuerung ist durch ein einfaches Zeitrelais realisierbar, das bei einer erneuten Bestromung des Gerätes (z.B. "Zündung an") mit der Ausheizphase startet und nach einem festen Zeitraster zwischen den Stellungen hin und her schaltet.

Nach einer bevorzugten Ausführungsform der Erfindung ist das Verstellelement als ein thermomechanisches Verstellelement ausgebildet, wobei die Adsorptionseinstellung und die Desorptionseinstellung durch Temperaturveränderung des thermomechanischen Verstellelementes vorgenommen wird. Vorteilhaft wird hierdurch das Verstellelement thermisch aktiviert, wobei ein ansonsten erforderlicher Stellmotor bzw. eine Ansteuerung desselben eingespart werden kann. Vorteilhaft kann hierdurch auch der Bauraumbedarf für die Bereitstellung eines gesteuerten Feuchtetransportes aus einer Gehäusekammer in eine Ausheizkammer verringert werden. Grundgedanke dieser bevorzugten Ausführungsform der Erfindung ist es, dass in dem Verstellelement selbst die Bewegungserzeugung erfolgt. Hieraus resultiert eine kompakte Bauweise der Trocknungseinrichtung.

Nach einer Weiterbildung der Erfindung ist das elektrische Heizelement in der Nähe des Verstellelementes bzw. der Trocknungsmittel derart angeordnet, dass vermittels einer auf das elektrische Heizelement wirkenden Steuereinrichtung nicht nur das Heizelement aktiviert bzw. deaktiviert wird, sondern darüber hinaus auch eine gezielte Bewegung des Verstellelementes von der Adsorptionseinstellung in die Desorptionseinstellung und umgekehrt erfolgt. Vorteilhaft dient die Ansteuerung des elektrischen Heizelementes zugleich als Ansteuerung für das thermomechanische Verstellelement. Der Steuerungsaufwand kann hierdurch wesentlich reduziert werden. Erfindungsgemäß kann die zum Trocknen bzw. Ausheizen des Verstellelementes vorgesehene und durch das Heizelement bereitgestellte Wärme zur Verstellung des Verstellelementes zwischen der Adsorptionseinstellung und der Desorptionseinstellung und umgekehrt genutzt werden.

Nach einer Weiterbildung der Erfindung umfasst das Verstellelement ein thermisch aktiviertes Dehnstelement, Bimetallelement oder Formgedächtniswerkstoffelement. Das Dehnstoffelement, das Bimetallelement oder das Formgedächtniswerkstoffelement ist in Verstellrichtung langgestreckt und/oder längenausdehnbar ausgebildet, so dass in Verbindung mit endseitigen Aufnahmen des Verstellelementes in der Gehäusekammer bzw. Ausheizkammer eine sichere und langzeitstabile Verstellung des Verstellelementes ermöglicht wird. Vorzugsweise ist das Verstellelement über Axialschieber in der Gehäusekammer bzw. Ausheizkammer gelagert, wobei die Axialschieber zum einen eine axial verschiebliche Lagerung des Verstellelementes und zum anderen eine Abdichtung der Gehäusekammer bzw. Ausheizkammer in der Adsorptionseinstellung bzw. Desorptionseinstellung ermöglichen.

Ausführungsbeispiele werden nachfolgend anhand der Zeichnungen näher erläutert.

Es zeigen:
- Fig. 1: einen Längsschnitt durch eine erste Trocknungseinrichtung für ein lichttechnisches Gerät, wobei ein ein Trocknungsmittel halterndes Verstellelement in Desorptionseinstellung angeordnet ist und das Trocknungsmittel in einer Ausheizvorkammer angeordnet ist,
- Fig. 2: einen Längsschnitt durch die Trocknungseinrichtung nach Fig. 1, wobei sich das Verstellelement in einer Transportphase befindet,
- Fig. 3: Einen Längsschnitt durch die Trocknungseinrichtung nach den Figuren 1 und 2, wobei das Verstellelement in einer Absorptionseinstellung und das Trocknungsmittel im Geräteinneren angeordnet ist,
- Fig. 4: einen Längsschnitt durch eine zweite Trocknungseinrichtung für ein lichttechnisches Gerät, wobei in eine Öffnung der Ausheizkammer zur Umgebungsluft des Gerätes durch eine dampfdurchlässige, wasserundurchlässige Membran verschlossen ist,
- Fig. 5: einen Längsschnitt durch eine Trocknungseinrichtung nach einer weiteren Ausführungsform in einer Adsorptionseinstellung und
- Fig. 6: die Trocknungseinrichtung gemäß Figur 5 in einer Desorptionseinstellung.

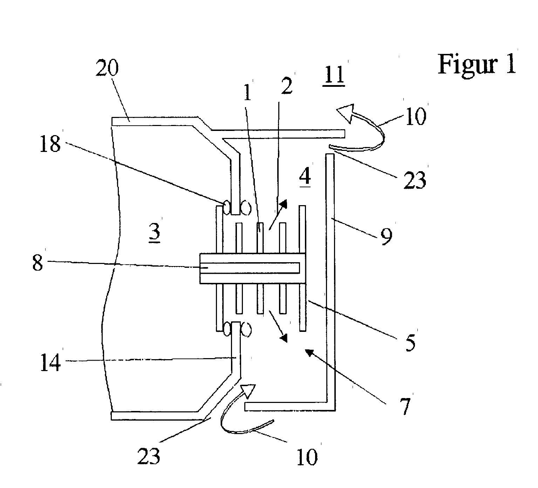

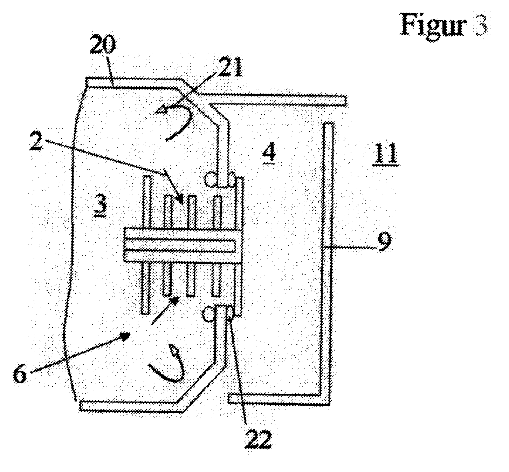

Das in den Figuren 1 bis 4 dargestellte lichttechnische Gerät ist ein Scheinwerfer für Kraftfahrzeuge. Der Scheinwerfer weist ein Gehäuse 20 auf, dessen Vorderseite durch eine lichtdurchlässige Abschlussscheibe abgeschlossen ist (nicht dargestellt) und das im Inneren ein Lichtmodul aufweist (nicht dargestellt). In einer Öffnung 19 einer Gehäusewand 14 ist ein elektrisch ansteuerbares Verstellelement 5 einer Trocknungseinrichtung angeordnet. Das Verstellelement 5 ist seiltrommelartig ausgeführt und weist Seitenwände 13 und ein diese verbindendes Mittelstück 12 auf. An dem Mittelstück ist ein von einem rippenartigen Körper gebildetes Trocknungsmittel 1 angebracht. Das Trocknungsmittel 1 dient zur Aufnahme und Abgabe von Luftfeuchte 2. Durch das Verstellelement 5 ist das Trocknungsmittel 1 von einer Adsorptionseinstellung 6 in eine Desorptionseinstellung 7 transportierbar. In der Adsorptionseinstellung 6 (Figur 3) liegt das Verstellelement 5 mit einer der Seitenwände 13 unter Zwischenschaltung einer umlaufenden Dichtung 22 luftdicht an der Gehäusewand 14 an und verschließt die Öffnung 19 luftdicht und das Trocknungsmittel 1 nimmt Luftfeuchte 2 aus der Innenluft 3 des Gehäuseteils 20 selbsttätig auf. Dabei besteht wegen dem Wärme erzeugenden Lichtmodul eine Luftkonvektion 21, durch die die Luftfeuchte 2 der Innenluft 3 zum Trocknungsmittel transportiert wird.

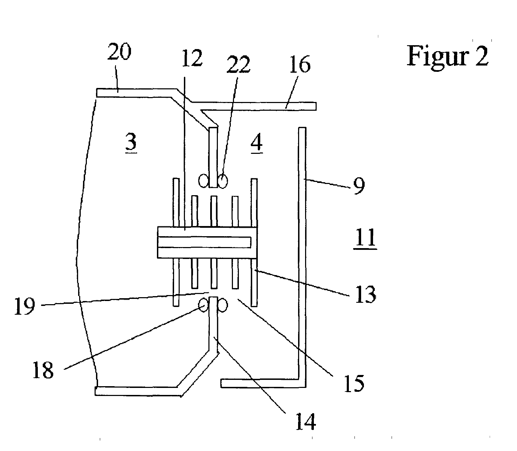

Die Bewegung von Adsorptionseinstellung 6 zur Desorptionseinstellung 7 erfolgt translatorisch (Figur 2). In der Desorptionseinstellung 7 (Figur 1) liegt das Verstellelement 5 nun mit der anderen Seitenwand 13 unter Zwischenschaltung einer umlaufenden Dichtung 18 an. Dabei ist die Öffnung 19 zur Innenluft 3 des Gehäuses 16 dicht verschlossen und das Trocknungsmittel 1 ist in einer Ausheizkammer 9 des Gehäuses 16 angeordnet. In eine zentrale Bohrung des Mittelstücks 12 ist ein Heizelement 8 eingesetzt, durch das das Trocknungsmittel 1 in der Ausheizkammer 9 aufgeheizt wird und die von der Innenluft 3 aufgenommene Luftfeuchte 2 an die von der Ausheizkammer 9 begrenzte Außenluft abgibt.

In den Figuren 1 bis 3 weist die Ausheizkammer 9 eine obere und untere Belüftungsöffnung 23 auf, durch die durch Luftkonvektion 10 die Luftfeuchte 2 in den das Gehäuse 16 umgebenden Gasraum 11 abgegeben wird.

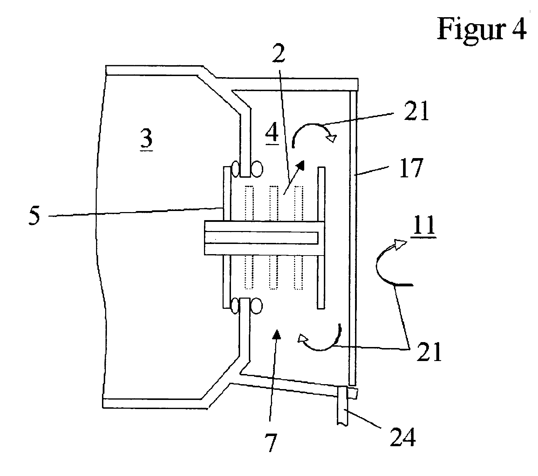

In Figur 4 weist eine Wand des Gehäuses 16 eine wasserundurchlässige und dampfdurchlässige Membran 17 auf, durch die die desorbierte Luftfeuchte 2 in der Außenluft 4 auf diffusivem Wege in den Gasraum 11 der Gehäuseumgebung gelangt. Für im Inneren der Ausheizkammer 9 durch Kondensation angesammeltes Wasser ist diese mit einem Abflussrohr 24 verbunden. Ein solches Gerät ist watfähig.

Das Verstellelement 5 ist im stromlosen Zustand des lichttechnischen oder elektrischen Geräts derart ansteuerbar, dass das Verstellelement 5 sich in eine mittlere Stellung zwischen der Adsorptionseinstellung und der Desorptionseinstellung verstellt und zwischen dem Verstellelement der Trocknungseinrichtung mindestens eine ringförmige Belüftungsöffnung 15 zwischen Innenluft 3 und Außenluft 4 verbleibt. Weiterhin kann das Gehäuseteil 20 zumindest eine Belüftungsöffnung zwischen Innenluft 3 und Gasraum 11 aufweisen.

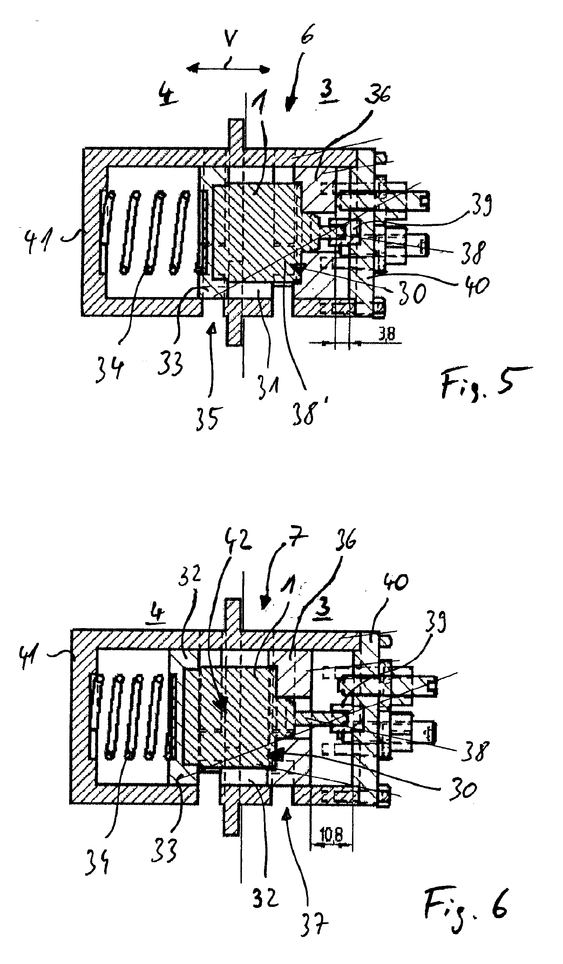

Nach einer weiteren Ausführungsform einer Trocknungseinrichtung gemäß den Figuren 5 und 6 ist ein thermomechanisches Verstellelement 30 vorgesehen, das in Verstellrichtung V zwischen einer die Feuchtigkeit der in einer Gehäusekammer 31 des Gerätes befindlichen Innenluft 3 aufnehmenden Adsorptionseinstellung 6 und einer die Feuchtigkeit der Innenluft 3 an die Umgebungsluft einer Ausheizkammer 32 abgebenden Desorptionseinstellung 7 beweglich gelagert ist. Hierzu ist eine auf einer der Ausheizkammer 32 zugewandten Seite angeordnete Stirnseite des Verstellelementes 30 an einem ersten Axialschieber 33 gelagert. Der erste Axialschieber 33 und somit das Verstellelement 30 ist über eine Feder 34 federvorgespannt angeordnet, so dass ein Hauptabschnitt des Trocknungsmittels 1 des Verstellelementes 30 in der Gehäusekammer 31 bzw. in der Adsorptionseinstellung 6 befindet. In dieser Stellung dichtet der erste Axialschieber 33 das Verstellelement 30 gegenüber einer Belüftungsöffnung 35 der Ausheizkammer 32 vollständig ab. Wie aus Figur 5 zu ersehen ist, ist das mit dem Trocknungsmittel 1 versehene Verstellelement 30 in der Adsorptionseinstellung 6 in der Lage, die Feuchtigkeit der Innenluft 3 des Gerätes bzw. der Gehäusekammer 31 aufzunehmen.

Auf einer der Gehäusekammer 31 zugewandten Stirnseite des Verstellelementes 30 ist ein zweiter Axialschieber 36 angeordnet, mittels dessen das Verstellelement 30 in der gemäß Figur 6 dargestellten Desorptionseinstellung 7 gegenüber der Gehäusekammer 31 bzw. einer Seitenöffnung 37 der Gehäusekammer 31 abgedichtet ist. Ein Hauptabschnitt des Trocknungsmittels 1 des Verstellelementes 30 befindet sich innerhalb der Ausheizkammer 32, so dass die Feuchtigkeit an die Außenluft 4 abgegeben und damit eine Regeneration des Trocknungsmittels 1 erfolgen kann.

Das Verstellelement 30 ist als ein Dehnstoffaktor ausgebildet und weist ein Dehnstoffelement 38' auf, das in Abhängigkeit von der Temperatur in Verstellrichtung (Axialrichtung) bewegbar ist. Alternativ kann das Verstellelement auch als ein Bimetallelement ausgebildet sein, der über zwei Werkstoffe mit unterschiedlichen TemperaturAusdehnungskoeffizienten verfügt. Alternativ kann das Verstellelement auch als ein Formgedächtniswekstoffelement ausgebildet sein.

Das Dehnstoffelement 38' besitzt einen Axialkolben 38, der in einem Grundkörper des Verstellelementes 30 befestigt ist. Der Axialkolben 38 ist in Verstellrichtung V langgestreckt ausgebildet und ist mit einem freien Ende in einer Aufnahme 39 eines ortsfesten Trägers 40 gelagert. Der Träger 40 kann als eine Abschlussplatte ausgebildet sein, die zum Abschluss eines zylinderförmigen Grundkörpers 41 stirnseitig an demselben angeschraubt ist. Der Grundkörper 41 umfasst zum einen die Ausheizkammer 32 und die Gehäusekammer 31. Der Träger 40 schließt dabei eine Stirnseite der Gehäusekammer 31 ab.

Gleiche Bauteile bzw. Funktionen der beschriebenen Ausführungsbeispiele werden mit den gleichen Bezugsziffern gekennzeichnet.

Zur Regeneration des Trocknungsmittels 1, das außenseitig an einem Basiskörper 42 des Verstellelementes 30 angeordnet ist, wird das in dem Basiskörper 42 integrierte Heizelement 8 mittels einer nicht dargestellten Steuereinrichtung eingeschaltet, so dass das Trocknungsmittel 1 bzw. der Dehnstoffelement 38' erwärmt werden. Durch die Erwärmung des Dehnstoffelementes 38' wird der Axialkolben 38 relativ zu dem Basiskörper 42 bewegt, wobei durch die ortsfeste Lagerung des freien Endes des Axialkolbens 38 an dem Träger 40 der Basiskörper 42 des Verstellelementes 30 und damit das Trocknungsmittel 1 entgegen der Kraft der Feder 34 axial in Richtung der Ausheizkammer 32 verschoben wird. Das Dehnstoffelement 38' ist derart ausgelegt, dass sich das Verstellelement 30 so weit verstellt, dass der zweite Axialschieber 36 die Seitenöffnung 37 verschließt. Gleichzeitig gibt der erste Axialschieber 33 die Belüftungsöffnung 36 der Ausheizkammer 32 frei, so dass das Trocknungsmittel 1 nunmehr im Wesentlichen sich innerhalb der Ausheizkammer 32 befindet, wobei über die Außenluft 4 ein Austrag der Feuchtigkeit aus dem Trocknungsmittel 1 erfolgen kann.

Das Dehnstoffelement 38' ist derart ausgelegt, dass die mittels des Heizelementes 8 bewirkte Erwärmung ausreicht, die das Verstellelement 30 in der Adsorptionseinstellung 6 haltende Federkraft zu überwinden und das Verstellelement 30 in eine definierte Desorptionseinstellung 7 zu verbringen.

Sobald der Regenerationsvorgang abgeschlossen ist, kann durch Ausschalten des elektrischen Heizelementes 8 mittels der Steuereinrichtung zum einen der Heizvorgang und zum anderen die Zurückbewegung des Verstellelementes 30 aus der Desorptionseinstellung 7 in die Adsorptionseinstellung 6 bewirkt werden. Das Abschalten des Heizelementes 8 kann erfolgen, sobald ein vorgegebener Trocknungsgrad des Trocknungsmittels 1 erreicht ist. Dies kann zeitabhängig oder in Abhängigkeit von dem aktuellen Feuchtegrad des Trocknungsmittels 1 erfolgen. Das Verstellelement 30 bewegt sich aus der Desorptionseinstellung 7 in die Adsorptionseinstellung 6 zurück, sobald die Federkraft der Feder 34 größer ist als die durch den Axialkolben 38 übertragene axiale Verstellkraft.

Das elektrische Heizelement 8 kann beispielsweise durch in dem Basiskörper 42 des Verstellelementes 30 integrierte Wicklungen gebildet sein.

Nach einer bevorzugten Ausführungsform erfolgt die Ansteuerung des elektrischen Heizelementes 8 ausschließlich durch Ein- und Ausschalten des elektrischen Heizelementes 8 innerhalb eines elektrischen Stromkreises. Im eingeschalteten Zustand des Heizelementes 8 gibt dasselbe eine konstante Heizenergie ab.

Nach einer alternativen Ausführungsform der Erfindung kann die Heizleistung des Heizelementes 8 mittels der Steuereinrichtung auch stufenförmig oder kontinuierlich angehoben oder abgesenkt werden.

Die Axialverstellung des Verstellelementes 30 erfolgt mit relativ geringem Aufwand, da lediglich elektrische Leitungen für das elektrische Heizelement 8 dem Verstellelement 30 zugeführt werden müssen.

### Bezugszeichenliste:

- 1.: Trocknungsmittel
- 2.: Luftfeuchte
- 3.: Innenluft
- 4.: Außenluft
- 5.: Verstellelement
- 6.: Adsorptionseinstellung
- 7.: Desorptionseinstellung
- 8.: Heizelement
- 9.: Ausheizkammer
- 10.: Äußere konvektive Verbindung
- 11.: Äußerer Gasraum
- 12.: Mittelstück (Nr. fehlt in Zeichnungen)
- 13.: Seitenwände des Verstellelementes
- 14.: Gehäusewände des Gerätes
- 15.: Belüftungsöffnung
- 16.: Gehäuse der Ausheizvorkammer
- 17.: Membran
- 18.: Innere Dichtung
- 19.: Öffnung
- 20.: Gehäuseteil des Gerätes
- 21.: Innere Luftkonvektion
- 22.: Äußere Dichtung
- 23.: Belüfungsöffnung der Ausheizvorkammer
- 24.: Abflussrohr
- V: Verstellrichtung
- 30.: Thermomechanisches Verstellelement
- 31.: Gehäusekammer
- 32.: Ausheizkammer
- 33.: Erster Axialschieber
- 34.: Feder
- 35.: Belüftungsöffnung
- 36.: Zweiter Axialschieber
- 37.: Seitenöffnung
- 38.: Axialkolben
- 38'.: Dehnstoffelement
- 39.: Aufnahme
- 40.: Träger
- 41.: Grundkörper
- 42.: Basiskörper

## Patentansprüche

1. Trocknungseinrichtung für lichttechnische oder elektronische Geräte mit einem Trocknungsmittel (1), das zur Aufnahme von Luftfeuchte (2) aus einer im Inneren des Gerätes befindlichen Innenluft (3) und zur Abgabe einer aufgenommen Luftfeuchte (2) an eine Außenluft (4) dient, **dadurch gekennzeichnet, dass** ein elektrisch und/oder thermisch ansteuerbares Verstellelement (5) zwischen einer Adsorptions- und Desorptionseinstellung (6 und 7) bewegbar ist, wobei zumindest ein Teil des Trocknungsmittels (1) zeitweise in der Adsorptionseinstellung (6) mit der Innenluft (3) zur Aufnahme der Luftfeuchte (2) und zeitweise in der Desorptions-einstellung (7) mit der Außenluft (4) zur Abgabe der Luftfeuchte (2) in Verbindung steht.

2. Trocknungseinrichtung nach Anspruch 1, **dadurch gekennzeichnet, dass** das Trocknungsmittel (1) durch das elektrisch und/oder thermisch ansteuerbare Verstellelement (5) zwischen der Adsorptions- und Desorptionseinstellung (6 und 7) bewegbar ist.

3. Trocknungseinrichtung nach Anspruch 1 oder 2, **dadurch gekennzeichnet, dass** ein elektrisches Heizelement (8) in der Desorptionseinstellung (7) das Trocknungsmittel (1) zur Trocknung aufheizt.

4. Trocknungseinrichtung nach Anspruch 3, **dadurch gekennzeichnet, dass** das Heizelement (8) eine Heißluft, Strahlung oder konduktive Wärme erzeugende Einrichtung ist.

5. Trocknungseinrichtung nach Anspruch 3, **dadurch gekennzeichnet, dass** das Heizelement (8) eine mit dem Verstellelement (5) mitlaufende Kontaktheizung oder ortsfest angeordnet ist..

6. Trocknungseinrichtung nach einem der Ansprüche 3 bis 5, **dadurch gekennzeichnet, dass** das Heizelement (8) mit einer Temperaturregelung gekoppelt ist.

7. Trocknungseinrichtung nach einem der Ansprüche 1 bis 6, **dadurch gekennzeichnet, dass** das Verstellelement als ein thermomechanisches Verstellelement (30) ausgebildet ist, derart, dass bei Temperaturveränderung das Trocknungsmittel (1) zwischen einer die Feuchtigkeit der in einer Gehäusekammer (31) des Geräts befindlichen Innenluft (3) aufnehmenden Adsorptionseinstellung (6), in der sich das Trocknungsmittel (1) zumindest hauptsächlich in der Gehäusekammer (31) befindet, und einer die Feuchtigkeit der Innenluft (3) abgebenden Desorptionseinstellung (7), in der sich das Trocknungsmittel (1) zumindest hauptsächlich in der Ausheizkammer (9) befindet, bewegt wird.

8. Trocknungseinrichtung nach einem der Ansprüche 1 bis 7, **dadurch gekennzeichnet, dass** in dem thermomechanischen Verstellelement (30) das elektrische Heizelement (8) integriert angeordnet ist und dass eine Steuereinrichtung auf das elektrische Heizelement (8) derart einwirkt, dass in der Desorptionseinstellung (7) bei Erreichen eines vorgegebenen Trocknungsgrades des Trocknungsmittels (1) das Verstellelement (30) selbsttätig in die Adsorptionseinstellung (6) verbracht wird.

9. Trocknungseinrichtung nach einem der Ansprüche 1 bis 8, **dadurch gekennzeichnet, dass** das elektrische Heizelement (8) mittels der Steuereinrichtung derart angesteuert und/oder derart in einen Bereich des Trocknungsmittels (1) positioniert ist, dass mit Einschalten und/oder Aufheizen des Heizelementes (8) zumindest ein Hauptabschnitt des Trocknungsmittels (1) von der Adsorptionseinstellung (6) in die Desorptionseinstellung (7) bewegt wird.

10. Trocknungseinrichtung nach einem der Ansprüche 1 bis 9, **dadurch gekennzeichnet, dass** das elektrische Heizelement (8) mittels der Steuereinrichtung derart angesteuert ist, dass mit Abschalten und/oder Abkühlen des elektrischen Heizelementes (8) zumindest der Hauptabschnitt des Trocknungsmittels (1) von der Desorptionseinstellung (7) in die Adsorptionseinstellung (6) bewegt wird.

11. Trocknungseinrichtung nach einem der Ansprüche 1 bis 10, **dadurch gekennzeichnet, dass** in dem Verstellelement (30) ein Dehnstoffelement (38'), ein Bimetallelement oder ein Formgedächtniswerkstoffelement integriert angeordnet ist.

12. Trocknungseinrichtung nach einem der Ansprüche 1 bis 11, **dadurch gekennzeichnet, dass** das Dehnstoffelement (38') und/oder das Bimetallelement und/oder das Formgedächtniwerkstoffelement in Verstellrichtung (V) langgestreckt und/oder längenausdehnbar ausgebildet ist und dass ein Ende des Dehnstoffelementes (38') bzw. des Bimetallelement an einer Aufnahme (39) eines ortsfesten Trägers (40) abgestützt ist.

13. Trocknungseinrichtung nach einem der Ansprüche 1 bis 12, **dadurch gekennzeichnet, dass** das Verstellelement (30) auf einer der Ausheizkammer (32) zugewandten Stirnseite federvorgespannt in Verstellrichtung (V) gelagert ist.

14. Trocknungseinrichtung nach einem der Ansprüche 1 bis 13, **dadurch gekennzeichnet, dass** das Verstellelement (30) auf einer der Ausheizkammer (32) und/oder der Gehäusekammer (31) zugewandten Seite mit einer Stirnseite um einen Axialschieber (33, 36) gelagert ist, derart, dass in der Adsorptionseinstellung (6) eine Belüftungsöffnung (35) der Ausheizkammer (32) und der Desorptionseinstellung (7) eine Öffnung (37) der Gehäusekammer (31) verschlossen ist.

15. Trocknungseinrichtung nach einem der Ansprüche 1 bis 14, **dadurch gekennzeichnet, dass** in der Desorption- und Adsorptionseinstellung (6 und 7) das Gehäuseteil (20) zur Außenluft (4) hin frei von einer Belüftungsöffnung ist.

16. Trocknungseinrichtung nach einem der Ansprüche 1 bis 15, **dadurch gekennzeichnet, dass** Trocknungsmittel (1) in der Desorptionseinstellung (7) in einer von der Innenluft (3) des Gerätes abgetrennten und die Außenluft (4) aufweisenden Ausheizvorkammer (9) angeordnet ist, die eine konvektive und/oder diffusive Verbindung (10) zu einem Gasraum (11) der Geräteumgebung aufweist.

17. Trocknungseinrichtung nach einem der Ansprüche 1 bis 16, **dadurch gekennzeichnet, dass** das Verstellelement (5) entweder translatorisch und/oder rotatorisch diskontinuierlich oder abschnittsweise translatorisch und/oder rotatorisch kontinuierlich bewegbar ist, wobei das Trocknungsmittel (1) phasenweise aus der Innenluft (3) Luftfeuchte (2) aufnimmt und phasenweise die aufgenommen Luftfeuchte (2) an die Außenluft abgibt.

18. Trocknungseinrichtung nach Anspruch 17, **dadurch gekennzeichnet, dass** das Verstellelement (5) ein translatorisch bewegbares Hubelement ist, das seiltrommelartig ausgebildet ist und in einer stationären Desorptionseinstellung (7) und Adsorptionseinstellung (6) mit einem der durch ein Mittelstück (12) verbundenen umlaufendenden Seitenwände (13) umlaufend dicht an einer Gehäusewand (14) anliegt und an seinem Mittelstück (12) das Trocknungsmittel (1) aufweist.

19. Trocknungseinrichtung nach Anspruch 18, **dadurch gekennzeichnet, dass** das Verstellelement (5) im Mittelstück (12) eine Aufnahme für das Heizelement (8) aufweist.

20. Trocknungseinrichtung nach Anspruch 17, **dadurch gekennzeichnet, dass** das Verstellelement (5) ein kontinuierlich und mechanisch bewegtes endloses Band in einer Endlosschleife ist, das das Trocknungsmittel (1) aufweist und durch Dichtschlitze in dem Gehäuse hindurchgeht, wobei ein Abschnitt des Bandes mit der Außenluft (4) und ein Abschnitt der Bandes mit der Innenluft (3) in Verbindung steht.

21. Trocknungseinrichtung nach Anspruch 17, **dadurch gekennzeichnet, dass** das Verstellelement (5) eine rotierende Scheibe ist, die an den Stirnflächen im Inneren des Gerätes Luftfeuchte (2) aufnimmt und außerhalb des Gerätes durch Beheizung die Luftfeuchte (2) wieder abgibt.

22. Trocknungseinrichtung nach Anspruch 17, **dadurch gekennzeichnet, dass** das Verstellelement (5) ein rotierender Zylinder ist, der an der Mantelfläche im Inneren des Gerätes Luftfeuchte (2) der Innenluft (3) aufnimmt und außerhalb des Gerätes durch Beheizung die Luftfeuchte (2) an die Außenluft (4) wieder abgibt.

23. Trocknungseinrichtung nach einem der Ansprüche 1 bis 22, **dadurch gekennzeichnet, dass** eine mechanische und/oder elektrische Verstelleinrichtung im stromlosen Zustand der Trocknungseinrichtung mindestens eine Belüftungsöffnung (15) im Gehäuse (20) aktiviert.

24. Trocknungseinrichtung nach einem der vorstehenden Ansprüche, **dadurch gekennzeichnet, dass** die Ausheizvorkammer (9) in einem Wandteil des Gehäuses (16) eine wasserundurchlässige und dampfdurchlässige Membran (17) aufweist, durch die die desorbierte Luftfeuchte (2) in der Außenluft (4) auf diffusivem Wege in den Gasraum (11) der Geräteumgebung gelangt

25. Trocknungseinrichtung nach Anspruch 24, **dadurch gekennzeichnet, dass** die Ausheizvorkammer (9) und das Gehäuseteil (20) druckdicht gegenüber dem Gasraum (11) sind.

26. Trocknungseinrichtung nach Anspruch 24, **dadurch gekennzeichnet, dass** die Ausheizvorkammer (9) einen Kondensatabfluss an der tiefsten Stelle aufweist.

27. Trocknungseinrichtung nach einem der vorstehenden Ansprüche, **dadurch gekennzeichnet, dass** das lichttechnische Gerät ein Scheinwerfer für Fahrzeuge ist, dessen Gehäuse auf seiner Vorderseite eine lichtdurchlässige Abschlussscheibe und im Inneren mindestens eine Wärme abgebende elektrische Einrichtung aufweist.

28. Trocknungseinrichtung nach einem der vorstehenden Ansprüche, **dadurch gekennzeichnet, dass** das Trocknungsmittel (1) von einem verrippten und/oder porösen oder von Luftkanälen durchzogener Trockenmittelkörper gebildet ist.

29. Trocknungseinrichtung nach einem der vorstehenden Ansprüche, **dadurch gekennzeichnet, dass** auf einem Oberflächenabschnitt des Verstellelements (5) das Trocknungsmittel (1) als Schicht aufgebracht ist.

30. Trocknungseinrichtung nach einem der vorstehenden Ansprüche, **dadurch gekennzeichnet, dass** bei einer kontinuierlichen Bewegung des Verstellelements (5) diese und die Heizleistung des Heizelements (8) konstant ist.

31. Trocknungseinrichtung nach einem der vorstehenden Ansprüche 1 bis 30, **dadurch gekennzeichnet, dass** bei einer diskontinuierlichen Bewegung des Verstellelements (5) ein Regelungssystem die Umschaltung zwischen Desorptions- und Adsorptionseinstellung (6 und 7) initiiert und zur Aktivierung und Deaktivierung des Heizelements (5) dient.

32. Trocknungseinrichtung nach Anspruch 31, **dadurch gekennzeichnet, dass** das Regelungssystem eine Steuerung mit einem festen Zeitraster ist.

33. Trocknungseinrichtung nach Anspruch 31, **dadurch gekennzeichnet, dass** durch bei einer kontinuierlichen bzw. diskontinuierlichen Bewegung des Verstellelements (5) ein Regelungssystem die Umlaufgeschwindigkeit bzw. Umschaltperiode in Abhängigkeit von der Dampfdruck-Differenz zwischen Innenluft (3) und Außenluft (4) regelt.

34. Trocknungseinrichtung nach einem der vorstehenden Ansprüche, **dadurch gekennzeichnet, dass** die Phase der Adsorptionseinstellung (6) länger ist als die der Desorptionseinstellung (7).
